# EUROPÄISCHE PATENTSCHRIFT

(11) **EP 0 459 478 B1**
(45) Veröffentlichungstag und Bekanntmachung des Hinweises auf die Patenterteilung: **15.05.1996**
(21) Anmeldenummer: 91108855.7
(22) Anmeldetag: 29.05.1991
(51) Int. Cl.: G01V 3/10

(54) **Vorrichtung zum Feststellen von relativ zu einer metallempfindlichen Sensoranordnung bewegten Metallteilen**
Apparatus determining the relative movement of metal with respect to a metal sensitive detector arrangement
Dispositif pour déterminer le mouvement relatif de métal par rapport à un dispositif détecteur de métaux

(30) Priorität: 01.06.1990 DE 4017780
(43) Veröffentlichungstag der Anmeldung: 04.12.1991
(73) Patentinhaber: Müller-Stürcken, Harro, Prof.Dipl.-Ing., D-36151 Burghaun (DE)
(72) Erfinder: Müller-Stürcken, Harro, Prof.Dipl.-Ing., D-36151 Burghaun (DE)
(74) Vertreter: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)

(56) Entgegenhaltungen:
- DE-B- 1 104 235
- GB-A- 1 510 034
- PATENT ABSTRACTS OF JAPAN vol. 9, no. 148 (P-366)22. Juni 1985 & JP-A-60025473

## Beschreibung

Die vorliegende Erfindung betrifft eine Vorrichtung zum Feststellen und Zählen von relativ zu einem metallempfindlichen Sensor bewegten Metallteilen nach dem Oberbegriff von Anspruch 1.

Bei der Produktion aller möglichen Industrieprodukte werden Tastanordnungen benötigt, die bewegte Metallteile erkennen können. So muß z.B. in der Stanzereitechnik nach jedem Stanzen kontrolliert werden, ob das Stanzteil die Werkzeugstation auch tatsächlich verlassen hat, bevor ein erneuter Hub ausgelöst wird. Nur so läßt sich ein Werkzeugbruch vermeiden.

Als weiteres Beispiel sei die Metallausscheidung bei rieselfähigen Schüttgütern, z.B. Kunststoffgranulat erwähnt, was insbesondere bei Recycling-Material vorkommt. Metallsplitter, die in den Extruder gelangen, können schwerwiegende Schäden verursachen, und zwar insbesondere an der Förderschnecke und der Spritzdüse.

Wichtig ist auch die Kontrolle von chemischen und pharmazeutischen Produkten, z.B. Tabletten oder Dragees, auf etwaige Metalleinschlüsse, welche durch Abriebe vom Werkzeug bei der Herstellung auftreten könne.

Auch bei der Kontrolle von Hydrauliksystemen können durch Verschluß Metallteile in der Hydraulikflüssigkeit enthalten sein. In diesem Falle ist es wichtig, dies frühzeitig zu erkennen, bevor an der Maschine größere Schäden auftreten.

Da bei all den geschilderten Aufgaben immer höhere Anforderungen an die Empfindlichkeit der Metalldetektoren gestellt werden, war es notwendig, eben diese Ansprechempfindlichkeit extrem zu steigern. Aus der DE-OS 21 57 824 ist ein Verfahren bekannt, mittels Einsatzes von kritisch gekoppelten Oszillatoren und rauscharmer Verstärker in Verbindung mit Schwingkreisen sehr hoher Güte die geforderte Empfindlichkeit zu erreichen. Hierbei ergeben sich jedoch im praktischen Einsatz erneut Probleme, da Störeinflüsse wie mechanische Stöße, wie sie z.B. beim Schließen eines Stanzwerkzeuges bei der Auswerfkontrolle oder beim Umschalten einer Sortierweiche bei Metallausscheidungsgeräten oder beim Auftreten von Druckspitzen beim Überwachen von Hydauliksystemen auftreten können, die die Elektronik des Sensors ebenfalls zum Ansprechen bringen können. Mit anderen Worten kann die an sich mögliche hohe Empfindlichkeit häufig nicht ausgenutzt werden, weil es dabei zu Fehlimpulsen und damit zu Fehlfeststellungen bzw. Fehlzählungen kommen kann.

Als weitere Störquelle sind Spannungsspitzen zu nennen, mit denen alle Industrienetze mehr oder weniger verseucht sind. Auch diese Spannungsspitzen, die ihre Ursache im Schalten großer Induktivitäten haben, können zu Fehlimpulsen führen, was die Steigerung der Empfindlichkeit begrenzt.

Aus der US-Patentschrift US 2 893 633 ist ein elektrisch zählendes System zum separaten Aufnehmen von Einheiten wie Fischen bekannt, die durch eine gegebene Öffnung oder an einem gegebenen Punkt vorbei in eine von zwei Richtungen treten. Das System erlaubt eine automatische Aufnahme der Anzahl und Ausbreitungsrichtung von Objekten wie Fischen.

Das System soll dazu dienen, die Richtung des Durchtrittes auf korrekte Weise zu identifizieren und lange Zeitverzögerungen, unsicheres Fortschreiten oder falsche Starts in der Öffnung zu berücksichtigen. Dabei ist als falscher Start anzusehen, wenn der Fisch auf dem Eintrittsweg wieder aus einem Zählwehr herausgelang.

Das System wirkt, indem drei parallele, hintereinander angeordnete Ringelektroden vorgesehen werden, die zu zwei Elektrodenpaaren mit einer gemeinsamen mittleren Elektrode verschaltet werden. Mittels zweier Brückenschaltkreise werden Signale aufgrund der Änderung der dielektrischen Konstante im Feld der Ringelektrode bei Durchtritt von Fischen nachgewiesen. Die Signale beaufschlagen eine Zählvorrichtung.

Demgemäß sieht die US 2 893 633 ein Zweirichtungsfischzählsystem mit einer isolierten Öffnung mit erweiterten Endabschnitten vor,durch welche der zu zählende Fisch treten muß. Die Vorrichtung umfaßt eine Vielzahl von zumindest zwei Elektrodenpaaren mit jeweils einer gemeinsamen Elektrode in beabstandeter sequentieller Zylinderausrichtung, die koinzident mit longitudinalen Achse der Öffnung ist und darin enthalten ist; eine Vielzahl von Detektormitteln, die mit jeweiligen Elektrodenpaaren zum Nachweis des Eintrittes in die Öffnung aus irgendeiner Richtung verbunden sind; ein System von Relays in bilateraler symmetrischer Beschaltung, um den Ausgang des Detektormittels zu korrelieren, das aus einer Vielzahl von Detektorrelays besteht, wobei eine Armatur, d.h. ein Anker, von jeden nur momentan die zugehörige Beschaltung durch den Transfer davon schließen soll, sowie eine Vielzahl von Halterelays mit einer Armatur-Transferrate vom Mehrfachen der Dauer der Detektorrelayarmaturtransferrate; und zwei elektrisch aufnehmende Zähler, die durch das Relaysystem so beaufschlagt werden, daß Zählungen von abgeschlossenen Durchtritten in einer Richtung durch die Öffnung auf einen Zähler gehalten werden, und Zählungen von abgeschlossenen Durchtritten in der entgegengesetzten Richtung auf dem anderen Zähler gehalten werden.

Es wird jedoch kein Hinweis gegeben, wie durch Störungen verursachtes Fehlerhaftes Ansprechen unterdrückt werden kann.

Die US-Patentschrift US 3 943 339 bezieht sich allgemein auf den Nachweis von Metallobjekten und insbesondere auf einen Detektor mit einer induktiven Schleife, der zum Nachweisen des Durchtrittes oder die Gegenwart eines Fahrzeuges über einen vorstehenden Bereich der Straße geeignet ist.

Das gennante Dokument ist darauf gerichtet, die Nachweisvorrichtung zu verbessern, indem eine gemeinsame Oszillator- und digitale logische Beschaltung auf effiziente Weise zwischen multiplen unabhängigen Schleifen-Kanälen zeitlich geteilt wird, um so die Verwendung von Ausrüstung zu optimieren und Übersprechen zwischen Schleifen-Kanälen zu vermeiden.

Dazu werden die Kanäle der induktiven Schleifen in Sequenz mit dem gemeinsamen Schleifenoszillatorschaltkreis verbunden und während jeder verbunden ist, wird eine Abtastung der Sequenz der Schleifenoszillation genommen. Diese Abtastung wird dann prompt mit einer abgespeicherten Referenz verglichen, die während einer oder mehrerer früherer Zeitperioden entwickelt wurde, um zu bestimmen, ob sich die Schleifenfrequenz geändert hat, und, falls dem so ist, ob die Änderung hinreichend ist, um einen bestimmten Zustand auszulösen.

Die GB-A-1 510 034 offenbart einen Näherungsdetektor mit einem elektrischen Oszillator, dessen Ausgabefrequenz von der Reaktanz einer Spule abhängt, welche auf einen magnetisch permeablen Kern angeordnet ist. In dem Detektor ist ein Mittel zum Erzeugen eines Magnetfeldes vorgesehen, welches den Kern in der Abwesenheit eines nachzuweisenden Objektes sättigt, aber das Objekt durchdringt, wenn es in der Nähe ist, und den Kern nicht sättigt. Ein Mittel zum Unterscheiden zwischen den Oszillatorausgabefrequenzen, die zu den ungesättigten und gesättigten Zuständen des Kerns gehören, um die Nähe des Objektes nachzuweisen, sind ebenfalls vorgesehen. In der GB-A-1 510 034 ist beschrieben, daß zwei oder mehrere Objektenachweisvorrichtungen zusammen in einem System verwendet werden können und zu einem richtungserfassenden Gerät kombiniert werden können, um die Gegenwart eines magnetischen Objektes und die Richtung seiner Bewegung zu erfassen.

In der Vorrichtung gemäß der GB-A-1 510 034 ist bereits eine logische Schaltung zur Auswertung der Detektorsignale vorgesehen. Diese Beschaltung wird als "Unterdrückungsschaltkreis" bezeichnet. Es ist vorgesehen, daß jedem einzelnen Sensor ein derartiger Unterdrückungsschaltkreis zugeordnet wird. Demgemäß ist eine Verknüpfung der Signale aus verschiedenen Sensoren nicht möglich. Vielmehr dient die logische Beschaltung dazu, sicherzustellen, daß bei einer Anwendung der Vorrichtung gemäß der GB-A-1 510 034 als Eisenbahn-Waggonrad-Detektor jedes Rad nur einmal gezählt wird.

Das Ziel der Erfindung besteht darin, eine Vorrichtung der eingangs genannten Gattung zu schaffen, die einerseits eine extrem hohe Ansprechempfindlichkeit für vorbeilaufende Metallteile aufweist, andererseits aber äußerst sicher gegen das Auftreten von Fehlimpulsen ist, die durch Störungen der geschilderten Art verursacht werden können.

Diese Aufgabe wird durch die Merkmale des unabhängigen Anspruchs 1 gelöst.

Vorteilhafte Ausführungsbeispiele sind in den abhängigen Ansprüchen beschrieben.

Die Erindung wird im folgenden beispielweise anhand der Zeichnungen beschrieben; in dieser zeigt:
- Fig. 1: eine Prinzipdarstellung einer erfindungsgemäßen Vorrichtung zum Feststellen bzw. Zählen von Metallteilen, wobei die Sensoranordnung in einer teilweise geschnittenen Seitenansicht gezeigt ist, und beispielsweise drei Tastebenen vorgesehen sind,
- Fig. 2: ein Blockschaltbild einer an die erfindungsgemäße Sensoranordnung angeschlossenen Logikschaltung als mögliches Ausführungsbeispiel, wobei die Logikschaltung auch auf eine andere geeignete Weise aufgebaut sein kann;
- Fig. 3: ein anderes Beispiel einer möglichen Logikschaltung und
- Fig. 4: mehrere zeitliche Impulsdiagramme, durch die die Funktion der Logikschaltungen nach den Fig. 2 und 3 veranschaulicht werden.

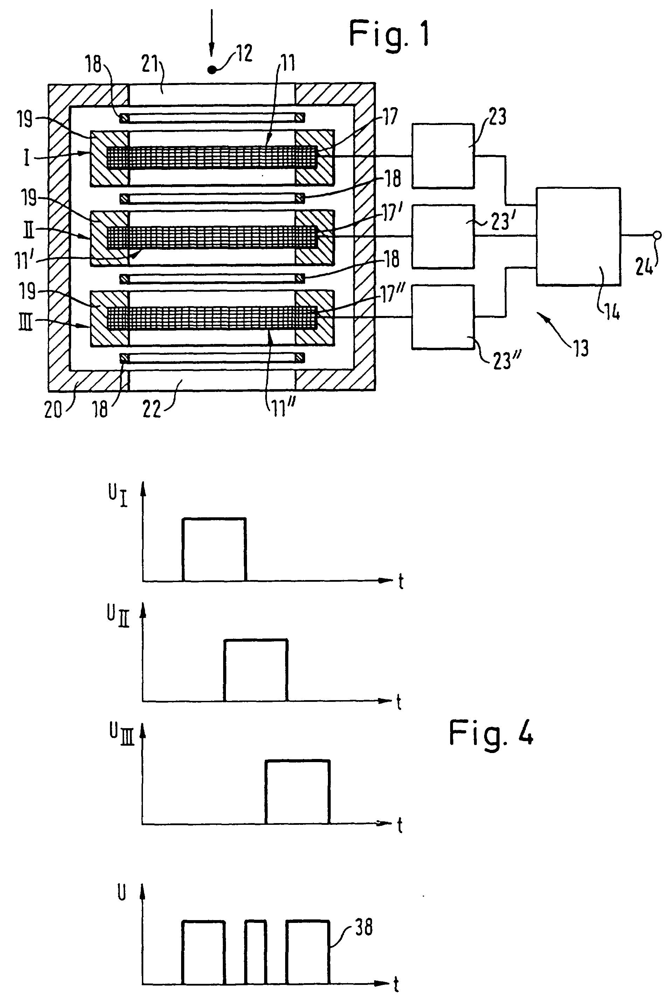

Nach Fig. 1 bilden beispielsweise drei flache im Abstand übereinander parallel angeordnete ringförmige Spulenwicklungen 17, 17', 17'' drei übereinander und parallel zueinander angeordnete Tastebenen I, II und III. Durch den freien Innenraum der Spulenwicklungen 17, 17', 17'' fallen von oben nach unten bei 12 angedeutete Metallteile im zeitlichen Abstand nacheinander hindurch.

Zwischen den Spulenwicklungen 17, 17', 17'' sowie beim Ein- und Auslauf sind Kurzschlußringe 18, vorzugsweise aus Kupfer vorgesehen, die die Aufgabe haben, diejenigen Feldlinien kurzzuschließen, die aus den einzelnen Tastebenen in die benachbarten Tastebenen hineinquellen. Zum Erreichen einer hohen Schwingkreisgüte sind die einzelnen Spulenanordnungen mit Ferritmänteln 19 versehen.

Somit bilden die einzelnen Spulenwicklungen 17, 17', 17'' mit den Ferritmänteln 19 und den sie gegeneinander abgrenzenden Kurzschlußringen 18 drei übereinander angeordnete entkoppelte Teilsensoren 11, 11', 11''. Die Sensoranordnung 11, 11', 11'' ist in einem Metallgehäuse 20 angeordnet, welches oben eine Eintrittsöffnung 21 und unten eine Austrittsöffnung 22 für die Metallteile 12, bzw. das mit Metallteilen verseuchte Schüttgut aufweist. Auf diese Weise wird eine Beeinflussung der Sensoranordnung 11, 11', 11'' von außen von nahezu jeglicher elektrischen Beeinflussung unterbunden.

Die einzelnen Spulenwicklungen 17, 17', 17'' sind Bestandteil von Oszillatoren 23, 23', 23'', die erfindungsgemäß unterschiedliche Frequenzen aufweisen, um die gegenseitige Entkopplung der Tastebenen I, II und III weiter zu vervollständigen. Für jede Tastebene I, II und III ist ein eigener Oszillator 23, 23', 23'' vorgesehen.

Die Oszillatoren 23, 23', 23'' sind so ausgebildet, daß nach entsprechender Verstärkung am Ausgang beim Durchlaufen eines Metallteilchens 12 durch die Spulenwicklungen 17, 17', 17'' hindurch ein Rechteckimpuls entsteht.

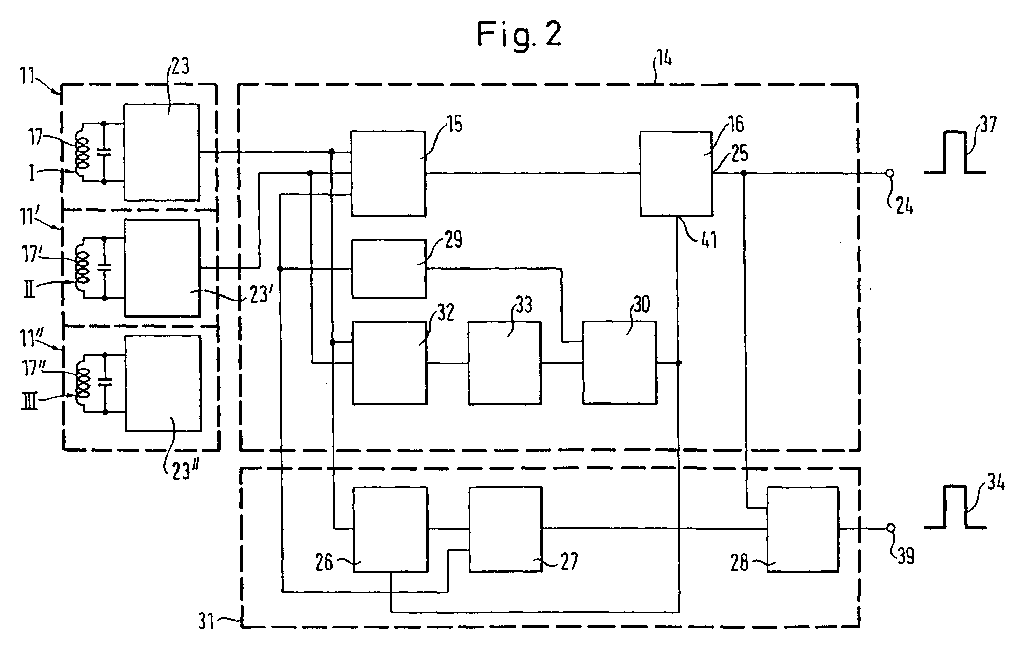

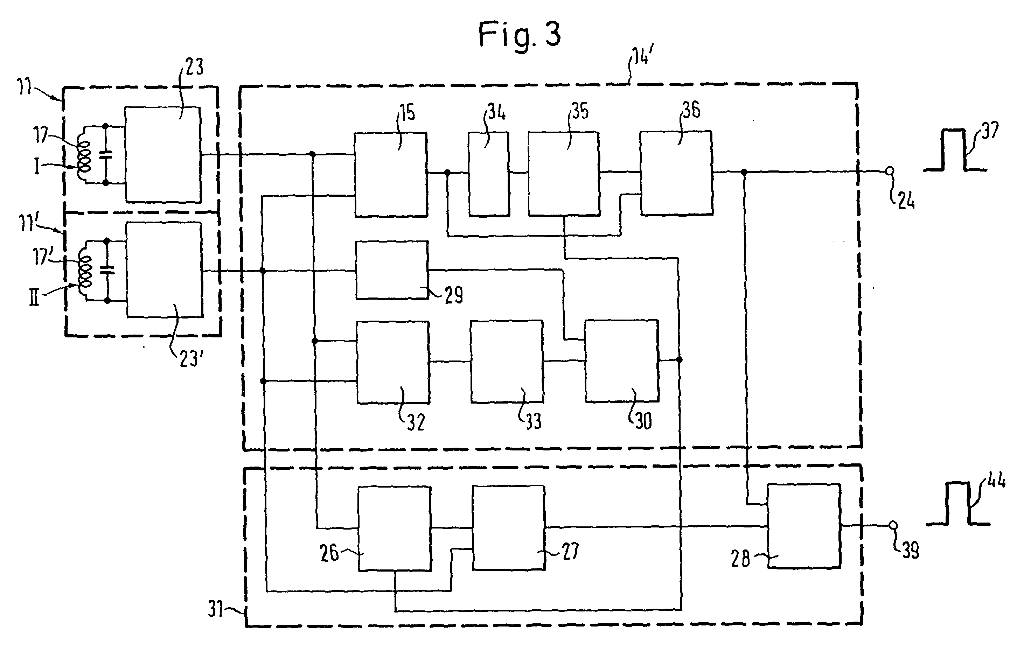

Die Ausgänge aller drei Oszillatoren 23, 23', 23'' sind an eine Logikschaltung 14 angeschlossen, die demnach die Rechteckimpulse empfängt und so ausgebildet ist, daß dann und nur dann am Ausgang 24 ein Ausgangssignal auftritt, wenn am Eingang der Logikschaltung 14 (Fig. 2) bzw. 14' (Fig. 3) eine Impulsfolge mit drei (zwei) zeitlich in einem bestimmten kurzen Abstand aufeinanderfolgenden Impulsen auftritt. Die gesamte Sensorelektronik, die aus den einzelnen HF-Generatoren und der Logikschaltung besteht, ist mit der Bezugszahl 13 bezeichnet.

Eine bevorzugte Ausführungsform einer Logikschaltung 14 ist in Fig. 2 dargestellt, in der gleiche Bezugszahlen entsprechende Bauteile wie in Fig. 1 bezeichnen. Die drei Spulenwicklungen 17, 17', 17'' der drei Tastebenen I, II und III sind wieder an die Generatoren 23, 23', 23'' angeschlossen, welche beim Hindurchfallen eines Metallteilchens 12 (Fig. 1) Impulse abgeben, weil sie in Fig. 4 in den ersten drei Diagrammen wiedergegeben sind. Das erste Diagramm gibt den Rechteckimpuls am Ausgang des Oszillators 23, das zweite Diagramm den Rechteckimpuls am Ausgang des zweiten Oszillators 23' und das dritte Diagramm den Rechteckimpuls am Ausgang des dritten Oszillators 23'' wieder. Es entstehen also insgesamt drei zeitlich versetzte Rechteckimpulse, die sich zeitlich überlappen können.

Die Ausgänge der Oszillatoren 23, 23', 23'', sind an die Eingänge eines Exklusiv-ODER-Gatters 15 angeschlossen, an dessen Ausgang nun eine Impulsfolge erscheint, wie sie im vierten Diagramm von Fig. 4 angegeben ist. Das Exklusiv-ODER-Gatter 15 gibt nur dann ein Ausgangssignal ab, wenn nur an einem der Eingänge ein Signal vorhanden ist.

Die am Exklusiv-ODER-Gatter 15 beim Durchlaufen eines Metallteilchens 12 erscheinende Impulsfolge gemäß dem vierten Diagramm von Fig. 4 werden dem Eingang eines Zählers 16 zugeführt, welcher an seinem Ausgang 25 immer dann ein Signal abgibt, wenn drei Impulse gezählt worden sind. Der Ausgang 24 der Logikschaltung 14 wird also mit einem einzigen Impuls 27 beaufschlagt, der anzeigt, daß ein Metallteilchen 12 die Sensoranordnung 11, 11', 11'' durchlaufen hat.

Die abfallende Flanke 28 des letzten Impulses (Fig. 4) kann über eine in Fig. 2 angedeutete Hilfsschaltung 29 (Umkehrstufe) und ein ODER-Gatter 30 den Rückstelleingang 31 des Zählers 16 beaufschlagen, wodurch der Zähler 16 nach dem Erscheinen von drei Impulsen aufgrund des Durchlaufens eines Metallteilchens 12 wieder zurückgestellt wird und für den nächsten Zählvorgang bereit ist.

Während also die von durchfallenden Metallteilchen 12 erzeugten Rechteckimpulse zeitlich nacheinander auftreten, erscheinen Störimpulse gleichzeitig. Dies ergibt zwar an den Ausgängen der Generatoren 23, 23', 23'' auch Impulse. Da diese aber gleichzeitig auftreten, werden sie durch das Exklusiv-ODER-Gatter 15 unterdrückt. Am Ausgang 24 kann also kein Impuls entstehen.

Sollte ein kleiner Störimpuls nur einen Teilsensor beeinflussen, also an einem Ausgang der Generatoren 23, 23', 23'' ein Impuls erscheinen, so wird dieser durch das Exklusiv-ODER-Gatter 15 nicht unterdrückt und stellt auch den Zähler 16 auf eins, nicht aber auf drei. Ein Ausgangsimpuls 27 erscheint also auch in diesem Fall nicht.

Um jedoch auch in diesem speziellen Falle des Auftretens eines Störimpulses an einem der Ausgänge der Generatoren 23, 23', 23'' den Zähler 16 wieder auf Null rückzustellen, sind die Ausgänge der Oszillatoren 23, 23', 23'' an die drei Eingänge eines weiteren ODER-Gatters 32 angeschlossen, welches über eine Verzögerungsstufe 33 und das weitere ODER-Gatter 30 die Rückstellung des Zählers 16 etwa nach einer Zeit auslöst, die etwas länger als die Gesamtzeit der Impulsfolge des vierten Diagrammes von Fig. 4 ist. Kurze Zeit nach Auftreten eines Störimpulses ist also der Zähler 16 für eine weitere Zählung wieder bereit.

Wie angeführt wurde ein Tastsystem mit drei Ebenen nur als Beispiel zur Erläuterung des Prinzips der Erfindung gewählt. Die Anzahl der Tastebenen ist willkürlich, wobei sicherlich die Störimpulsfestigkeit mit Zunahme der Anzahl der Tastebenen ansteigt. Die Bauhöhe einer Tastebene läßt sich konstruktiv zwar sehr gering halten, dennoch bestehen hinsichtlich der möglichen Bauhöhe bei speziellen technischen Aufgaben oft Grenzen, so daß mit der geringst möglichen Anzahl von Tastebenen, nämlich zwei, gearbeitet werden muß. Um auch in diesem Falle die Vorteile der Anordnung gemäß der Erfindung bestmöglich auswerten zu können, kann der Logik 14 ein weiteres Kriterium zugeordnet werden. Dies ist erfindungsgemäß die Bewegungsrichtung des zu detektierenden Metallteiles 12. Bei den meisten Aufgaben kann ein Metallteilchen nur in einer bestimmten Richtung die Sensoranordnung passieren. Bei einem Metallausscheider für rieselfähige Schüttgüter kann z.B. ein zu detektierendes Metallteilchen den Sensor nur von oben nach unten durchlaufen.

Zur Einbeziehung der Bewegungsrichtung des zu detektierenden Metallteiles 12 in die Signalauswertung dient beispielsweise der Schaltungsteil 31 der Fig. 2. Hier wird das Ausgangssignal des Oszillators 23 zusätzlich dem Eingang eines Flip-Flops 26 zugeführt, welches so geschaltet ist, daß die Anstiegsflanke des Ausgangssignals des Oszillators 23 den Ausgang des Flip-Flops 26 auf L-Signal bringt (positive Logik). Dem Flip-Flop 26 nachgeschaltet ist ein UND-Glied 27, dessem zweiten Eingang das Ausgangssignal des Oszillators 23'' zugeführt ist. Passiert das Metallteil 12 die Anordnung von oben nach unten, so wird am Ausgang des UND-Gliedes 27 dann der Ausgangsimpuls des Oszillators 23'' anstehen, wenn zuvor der Ausgang des Oszillators 23 einen Impuls abgegeben hatte. Schaltet man zudem dem Zähler 16 und dem UND-Glied 27 ein weiteres UND-Glied 28 nach, so wird dann und nur dann am Ausgang 29 ein Impuls 34 erscheinen, wenn alle drei Oszillatoren 23, 23', 23'' (teils überlappend, was keine Bedingung ist aber auch nicht stört) nacheinander Impulse abgegeben haben und zusätzlich die Tastebenen I, II und III in der angegebenen Reihenfolge durchlaufen wurden. Die Rückstellung des Flip-Flops 26 erfolgt entweder durch die Rückflanke des Impulses, der vom Durchlaufen der dritten Tastebene stammt, also über die Hilfsschaltung 29 und das ODER-Gatter 30, oder aber von irgend einem Ausgangsimpuls der Tastebenen I, II oder III mittels des ODER-Gatters 32, des Zeitgliedees 33, dessen Funktion schon beschrieben wurde und des ODER-Gatters 30.

Die Schaltungsteile 32 und 33 und also auch das ODER-Glied 30 sind auch noch aus einem weiteren Grund vorteilhaft: Egal wie hoch man die Ansprechempfindlichkeit der Teilsensoren auch züchten mag, es wird immer einen Grenzbereich geben, bei dem beim Durchlaufen eines sehr kleinen Metallteilchens durch den Sensor am Ausgang eines Teilsensors gerade noch ein Ausgangsimpuls entsteht, am Ausgang eines anderen Teilsensors jedoch gerade kein Ausgangsimpuls mehr auftritt. In diesem Falle wäre es möglich, daß ohne die Schaltungsteile 32, 33 und 30 der Zähler 16 und falls vorhanden das Flip-Flop 26 nicht zurückgestellt werden. Besonders bei rund ausgebildeten induktiven Sonden ist die Tastempfindlichkeit stark ortsabhängig. In der Mitte ist physikalisch bedingt die Empfindlichkeit am geringsten und nimmt zur Wandung hin stark zu. Da ein Metallteilchen die Tastanordnung auch schräg durchlaufen kann, ist dieser Fall nie auszuschließen. Wird die Grenzempfindlichkeit einer Tastebene unterschritten, so wird bewußt dieses Teilchen nicht registriert, die Funktion der Gesamtanordnung bleibt aber gewährleistet.

Ist die Anzahl der Tastebenen gering, so läßt sich die erforderliche Logikfunktion auch mit wenigen Flip-Flops realisieren, was als mögliches weiteres Ausführungsbeispiel einer Anordnung gemäß der Erfindung in Fig. 3 dargestellt ist. Die Logikschaltung ist hierbei mit 14' bezeichnet. Gewählt wurde eine Anordnung, die nur zwei Tastebenen aufweist, in der ebenfalls gleiche Bezugszahlen entsprechende Bauteile bzw. Baugruppen wie in den Fig. 1 und 2 bezeichnen. Die zwei Spulenwicklungen 17 und 17' der zwei Tastebenen I und II sind wieder an die Generatoren 23 und 23' angeschlossen, welche beim Hindurchfallen eines Metallteilchens 12 (Fig. 1) Impulse abgeben wie sie in Fig. 4 in den ersten beiden Diagrammen wiedergegeben sind. Das erste Diagramm gibt den Rechteckimpuls am Ausgang des Oszillators 23, das zweite Diagramm den Rechteckimpuls am Ausgang des zweiten Oszillators 23' wieder. Es entstehen alsobei dieser Anordnung insgesamt zwei seitlich versetzte Rechteckimpulse, die sich überlappen können.

Die Ausgänge der Oszillatoren 23 und 23' sind an die Eingänge des Exklusiv-ODER-Gatters 15 angeschlossen, an dessen Ausgang beim Durchlaufen eines Metallteiles nun eine Impulsfolge von zwei Impulsen erscheint. Der Ausgang des Exklusiv-ODER-Gatters 15 ist mit einer Hilfsschaltung 34 (Umkehrstufe) und dem Eingang einer UND-Schaltung 36 verbunden. Der Ausgang der Hilfsschaltung 34 steuert ein Flip-Flop 35 an. Durch diese Anordnung wird erreicht, daß die Rückflanke des ersten Ausgangsimpulses des Exklusiv-ODER-Gatters 15 das Flip-Flop 35 so steuert, daß an dessen Ausgang und am ersten Eingang des UND-Gliedes 36 L-Signal erscheint. Tritt nun am Ausgang des Exklusiv-ODER-Gatters 15 der zweite Impuls auf, so erscheint dieser auch am zweiten Eingang des UND-Gatters 36, am Ausgang 24 erscheint ein Impuls 27.

Die Rückschaltung des Flip-Flops 35 erfolgt entweder durch die Rückflanke des Ausgangssignals des Oszillators 23', was durch die Schaltungsteile 29 und 30 erreicht wird, oder durch einen der beiden Ausgangsimpulse der Oszillatoren 23 oder 23', und zwar mittels der Schaltungsteile 32, 33 und 30 auf die gleiche Weise, wie das bei der Funktionsbeschreibung der Schaltung gemäß Fig. 2 angegeben wurde. Auch die Logik 14' (Fig. 3) läßt sich durch einen Schaltungsteil 31 richtungsabhängig gestalten. Wie bereits beschrieben, wird dann und nur dann ein Ausgangsimpuls 30 am Ausgang 29 des UND-Gatters 28 erscheinen, wenn beide Impulse in der richtigen Reihenfolge entstehen, also das zu detektierende Metallteil zuerst in der Tastebene I und zeitlich danach in der Tastebene II ein weiteres Signal auslöst.

Der Durchlaß der induktiven Sonden muß nicht rund sein, vielmehr ist es vorteilhaft, den Durchlaß schlitzförmig zu gestalten, wie das in der DE-PS 29 44 192 erläutert ist. Auch ist das Verfahren nicht auf induktiv wirkende Sensoren beschränkt, sondern erfindungsgemäß auch bei Sensoren, die andere physikalische Wirkmechanismen aufweisen, anwendbar, wenn bei hohen Empfindlichkeiten Störimpulse der beschriebenen Art unterdrückt werden müssen.

Auch erscheint eine Auswertung der Analogsignale denkbar, bei der auf geeignete Weise die beschriebenen Bedingungen erfüllt werden.

Die in den Fig. 2 und 3 angegebenen Schaltungen dienen nur als Beispiele für die Signalauswertung eines Sensors gemäß der Erfindung. Die Aufgabe, insbesondere die Logikschaltung läßt sich z.B. auch mittels eines Schieberegisters oder anderer geeigneter Baugruppen realisieren, was jedoch am Auswerteprinzip nichts ändert. Auch der gewählte Code kann noch erweitert werden, z.B. können schmale und breite Tastbereich kombiniert werden, und die Logikschaltung kann dementsprechend ausgebildet sein. Auch hierdurch kann die Störimpulsfestigkeit weiter gesteigert werden.

Zur Erzeugung einer Impulsfolge kann erfindungsgemäß auch eine Sensoranordnung mit nur einem Oszillator Verwendung finden, wenn die Schwingkreisspule in mehrere Teilspulen unterteilt ist. Der Aufbau entspricht dann wieder Fig. 1, wobei alle Teilspulen mit nur einem Oszillator verbunden sind, der nur auf einer Frequenz schwingt. Da in diesem Falle im Gegensatz zu einem Aufbau mit einem Exklusiv-ODER-Gatter keine Trennung überlappender Impulse möglich ist, ist darauf zu achten, daß das Metallteil mit Sicherheit den Wirkungsbereich einer Tastebene verlassen hat, bevor es in den Wirkungsbereich der folgenden Tastebene eindringt. Hierbei spielt neben der Größe des Metallteils selbst und dem Abstand der Tastebenen voneinander auch die Zeitkonstante, besonders bei geregelten Oszillatoren, wie auch die Geschwindigkeit des Metallteiles eine Rolle. Die Teilsensoren können auch in getrennten Gehäusen untergebracht sein; das bietet den Vorteil, den Abstand der Sensoren untereinander auch später noch verändern zu können.

Eine bevorzugte Störimpulssicherheit wird bereits erzielt, wenn nur mit zwei Teilsensoren bzw. Tastebenen gearbeitet wird, so daß erfindungsgemäß eine Ausführung mit nur zwei, höchstens drei Teilsensoren bzw. Tastebenen besonders vorteilhaft ist.

## Patentansprüche

1. Vorrichtung zum Feststellen und Zählen von relativ zu einem metallempfindlichen Sensor bewegten Metallteilen, wobei der Sensor bei einer vorbestimmten Annäherung, insbesondere dem Vorbeilaufen eines Metallteiles (12) einen elektrischen Impuls an eine Sensorelektronik (13) abgibt und
mehrere Teilsensoren (11, 11', 11'') aufweist, die derart hintereinander angeordnet sind, daß ein bestimmtes festzustellendes Metallteil (12) die Teilsensoren (11, 11', 11'') nacheinander zum Ansprechen bringt und
die Sensorelektronik (13) eine Logikschaltung (14, 14') enthält, die auf eine vorbestimmte Impulsfolge und insbesondere auf eine vorbestimmte Impulszahl anspricht,
dadurch gekennzeichnet
daß die Logikschaltung (14, 14') ein Exklusiv-ODER-Gatter (15) enthält, dessen eingang an die Teilsensoren (11, 11', 11'') angeschlossen ist und dessen Ausgang einen Zähler (16) beaufschlagt, der nach Zählung der vorbestimmten Impulszahl ein Festszellungs- bzw. Zählsignal abgibt, so daß die Sensorelektronik (13) dann und nur dann ein Ausgangssignal abgibt, wenn die Sensorelektronik (13) die durch das nacheinander erfolgende Ansprechen enstehende Impulsfolge als vorhanden ermittelt hat.

2. Vorrichtung nach Anspruch 1,
dadurch **gekennzeichnet**,
daß der Zähler (16) eine vorbestimmte Zeit nach Auftreten eines oder mehrerer Impulse rückgestellt wird.

3. Vorrichtung nach einem der vorhergehenden Ansprüche,
dadurch **gekennzeichnet**,
daß drei Teilsensoren (11, 11', 11'') hintereinander angeordnet sind.

4. Vorrichtung nach einem der vorhergehenden Ansprüche,
dadurch **gekennzeichnet,**
daß die Teilsensoren aus flachen, ringförmigen Wikklungen (17, 17', 17") bestehen, die vorzugsweise parallel zueinander in geringem Abstand mit ausgerichteten Achsen zueinander angeordnet sind, wobei bevorzugt zwischen den Wicklungen (17, 17', 17'') sowie beim Ein- und Auslauf Kurzschlußringe (18) vorzugsweise aus kupfer vorgesehen sind, und daß zweckmäßigerweise die einzelnen Spulenwicklungen (17, 17', 17'') mit Ferritmänteln (19) versehen sind.

5. Vorrichtung nach einem der vorhergehenden Ansprüche,
daurch **gekennzeichnet,**
daß die Sensoranordnung (11, 11', 11") in einem Metallgehäuse (20) angeordnet ist, das oben und unten die Öffnungen (21, 22) für das Hindurchtreten der festzustellenden Metallteile aufweist.

6. Vorrichtung nach einem der vorhergehenden Ansprüche,
dadurch **gekennzeichnet**,
daß jeder Teilsensor (11, 11', 11'') einen eigenen Oszillator (23, 23', 23'') aufweist, von denen insbesondere jeder eine andere Frequenz aufweist, und daß bevorzugt die Oszillatoren (23, 23', 23") so ausgebildet sind, daß sie beim Durchlaufen eines Metallteils am Ausgang Rechteckimpulse abgeben.

7. Vorrichtung nach einem der vorhergehenden Ansprüche,
dadurch **gekennzeichnet**,
daß auch die Bewegungsrichtung des zu detektierenden Metallteiles (12) berücksichtigt wird, indem die zeitliche Reihenfolge der auftretenden Impulse festgestellt wird, wobei bevorzugt der von einem Teilsensor abgegebene Impuls ein Flip-Flop (26) setzt und der Ausgang des Flip-Flops sowie eines folgenden Teilsensors einem UND-Gatter (27) zugeführt sind, dessen Ausgang mit dem Ausgang des Zählers (16) an ein weiteres UND-Gatter (28) angelegt ist, welches einen Ausgangsimpuls (34) dann und nur dann abgibt, wenn nicht nur die Teilsensoren (11, 11', 11'') nacheinander Impulse abgegeben haben, sondern zusätzlich auch die Tastebenen (I, II und III) in der angegebenen Reihenfolge durchlaufen wurden.

8. Vorrichtung nach Anspruch 2,
dadurch **gekennzeichnet**,
daß die Ausgänge der Teilsensoren (11, 11', 11") an die Eingänge eines weiteren ODER-Gatteres (32) angeschlossen sind, welches über eine Verzögerungsstufe (33) und ein weiteres ODER-Gatter (30), das vorzugsweise auch von einer auf die abfallende Flanke des letzten Impulses ansprechenden Hilfsschaltung (29) beaufschlagt ist, die Rückstellung des Zählers (16) etwa nach einer Zeit auslöst, die etwas länger als die Gesamtzeit der Gesamtimpulsfolge ist, und/oder daß die Logikschaltung (14') ein Exlusiv-ODER-Gatter (15) enthält, dessen Eingang an die Teilsensoren (11, 11', 11") angeschlossen ist und dessen Ausgang zum einen an den einen Eingang eines UND-Gatters (36) und zum anderen über eine Umkehrstufe (34) an ein Flip-Flop (35) angeschlossen ist, dessen Ausgang den zweiten Eingang des vorgenannten UND-Gliedes (36) ansteuert, wobei insbesondere die Rückschaltung des Flip-Flops (35) entweder durch die Rückflanke des Ausgangssignals des letzten Teilsensors (11') oder durch einen der beiden Ausgangsimpulse der Teilsensoren (11, 11') erfolgt, und/oder daß durch ein gemäß Anspruch 13 oder 14 aufgebautes Schaltungsteil (31) auch die Durchgangsrichtung des Metallteils durch die Teilsensoren (11, 11') berücksichtigt wird.

9. Vorrichtung nach Anspruch 2,
dadurch **gekennzeichnet**,
daß die Logikschaltung durch ein Schieberegister gebildet ist.

10. Vorrichtung nach einem der vorhergehenden Ansprüche,
dadurch **gekennzeichnet**,
daß die Teilsensoren (11, 11', 11") teilweise schmale und teilsweise breite Tastbereiche aufweisen und die anschließende Logikschaltung auch hierauf abgestimmt ist, wobei vorteilhafterweise alle Teilsensoren nur an einen einzelnen Oszillator angeschlossen sind, der nur mit einer Frequenz schwingt, wobei die Tastebenen so zueinander angeordnet sind, daß keine Überlappung benachbarter Ausgangs impulse auftritt.

## Claims

1. Apparatus for detecting and counting metal parts which move relative to a metal-sensitive sensor, wherein the sensor, with a predetermined approach of a metal part (12), and in particular movement past it of a metal part (12), transmits an electrical pulse to an electronic sensor circuit (13) and has a plurality of part sensors (11, 11', 11") which are arranged behind one another in such a way that a specific metal part (12) to be detected causes the part sensors (11, 11', 11") to respond one after the other, and wherein the electronic sensor circuit (13) contains a logic circuit (14, 14') which responds to a predetermined pulse sequence, and in particular to a predetermined number of pulses, characterised in that the logic circuit (14, 14') contains an exclusive OR-gate (15) the input of which is connected to the part sensors (11, 11', 11") and the output of which acts on a counter (16) which, after counting the predetermined number of pulses, transmits a detection or count signal, so that the electronic sensor circuit (13) then, and only then, transmits an output signal when the electronic sensor circuit (13) has detected that the pulse sequence which arises through the sequential response is present.

2. Apparatus in accordance with claim 1, characterised in that the counter (16) is reset a specific time after the appearance of one or more pulses.

3. Apparatus in accordance with one of the preceding claims, characterised in that the three part sensors (11, 11', 11") are arranged one after the other.

4. Apparatus in accordance with one of the preceding claims, characterised in that the part sensors consist of flat, ring-like windings (17, 17', 17") which are preferably arranged parallel to one another at a small spacing with their axes aligned with one another, wherein short circuit rings (18), preferably of copper, are provided between the windings (17, 17', 17"), and also at the entry and at the exit; and in that the individual coil windings (17, 17', 17") are expediently provided with ferrite jackets (19).

5. Apparatus in accordance with one of the preceding claims, characterised in that the sensor arrangement (11, 11', 11") is arranged in a metallic housing (20) which has the openings (21, 22) at the top and at the bottom for the passage therethrough of the metal parts to be detected.

6. Apparatus in accordance with one of the preceding claims, characterised in that each part sensor (11, 11', 11") has its own oscillator (23, 23', 23"), each oscillator having, in particular, a different frequency;and in that the oscillators (23, 23', 23") are preferably so formed that they transmit rectangular pulses at the output on the through-passage of a metal part.

7. Apparatus in accordance with one of the preceding claims, characterised in that the direction of movement of the metal part (12) to be detected is also taken into account in that the time sequence of the pulses which arise is detected, with the pulse transmitted from one part sensor preferably setting a flip-flop (26) and the output of the flip-flop, and also of a following part sensor being supplied to an AND-gate (27), the output of which is applied together with the output of the counter (16) to a further AND-gate (28) which transmits an output pulse (34) then, and only then, when not only the part sensors (11, 11', 11") have transmitted pulses one after the other, but rather additionally when the sensing planes (I, II, and III) have been passed through in the given sequence.

8. Apparatus in accordance with claim 2, characterised in that the outputs of the part sensors (11, 11', 11") are connected to the inputs of a further OR-gate (32) which, via a delay stage (33) and a further OR-gate (30), which is preferably also acted on by an auxiliary circuit (29) which responds to the falling flank of the last pulse, brings about the resetting of the counter (16) after a time which is somewhat longer than the total time of the total pulse sequence; and/or in that the logic circuit (14') contains an exclusive OR-gate (15), the input of which is connected to the part sensors (11, 11', 11") and the output of which is connected, on the one hand, to the one input of an AND-gate (36) and, on the other hand, via an inverting stage (34) to a flip-flop (35), the output of which controls the second input of the above-named AND-gate (36), with the resetting of the flip-flop (35) in particular taking place either via the rear flank of the output signal of the last part sensor (11'), or by one of the two output pulses of the part sensors (11, 11'), and/or in that the direction of passage of the metal part through the part sensors (11, 11') is also taken into account by a circuit part (31) built up in accordance with claim 13 or claim 14.

9. Apparatus in accordance with claim 2, characterised in that the logic circuit is formed by a shift register.

10. Apparatus in accordance with one of the preceding claims, characterised in that the part sensors (11, 11', 11") partly have narrow sensing regions and partly have broad sensing regions and the subsequent logic circuit is matched to this, with all part sensors being advantageously connected to only a single oscillator which only oscillates with one frequency, with the sensing planes being so arranged relative to one another that no overlap of neighbouring output pulses arises.

## Revendications

1. Dispositif pour détecter et compter des pièces métalliques déplacées par rapport à un détecteur sensible aux métaux, le détecteur envoyant une impulsion électrique à une unité électronique de détection (13) lors d'un rapprochement déterminé, en particulier lors du passage d'une pièce métallique (12), et présentant plusieurs détecteurs partiels (11, 11', 11''), qui sont agencés les uns derrière les autres de telle sorte qu'une certaine pièce métallique à détecter (12) fait répondre les détecteurs partiels (11, 11', 11'') successivement l'un après l'autre, et l'unité électronique de détection (13) comporte un circuit logique (14, 14') qui répond à une succession d'impulsions prédéterminée et en particulier à un certain nombre d'impulsions prédéterminé, caractérisé en ce que le circuit logique (14, 14') comporte un élément OU exclusif (15) dont l'entrée est raccordée aux détecteurs partiels (11, 11', 11''), et dont la sortie attaque un compteur (16) qui envoie, après avoir compté le nombre d'impulsions prédéterminé, un signal de détection ou de comptage, de sorte que l'unité électronique de détection (13) envoie un signal de sortie seulement et uniquement lorsque l'unité électronique de détection (13) a détecté la présence de la succession d'impulsions qui se développe par la réponse successive.

2. Dispositif selon la revendication 1, caractérisé en ce que le compteur (16) est remis à zéro après un temps prédéterminé après apparition d'une ou de plusieurs impulsions.

3. Dispositif selon l'une ou l'autre des revendications précédentes, caractérisé en ce que trois détecteurs partiels (11, 11', 11'') sont agencés les uns derrière les autres.

4. Dispositif selon l'une quelconque des revendications précédentes, caractérisé en ce que les détecteurs partiels sont constitués par des enroulements plats annulaires (17, 17', 17") qui sont agencés de préférence parallèlement les uns aux autres à une faible distance avec alignement de leurs axes les uns par rapport aux autres, en ce qu'il est prévu de préférence entre les enroulements (17, 17', 17''), ainsi qu'à l'entrée et à la sortie, des bagues en court-circuit (18) constituées de préférence en cuivre, et en ce que les enroulements individuels (17, 17', 17") sont judicieusement pourvus d'enveloppes en ferrite (19).

5. Dispositif selon l'une quelconque des revendications précédentes, caractérisé en ce que l'agencement de détecteurs (11, 11', 11'') est agencé dans un boîtier métallique (20) qui présente en haut et en bas les ouvertures (21, 22) pour le passage des pièces métalliques à détecter.

6. Dispositif selon l'une quelconque des revendications précédentes, caractérisé en ce que chaque détecteur partiel (11, 11', 11'') présente un propre oscillateur (23, 23', 23") dont chacun présente en particulier une autre fréquence, et en ce que les oscillateurs (23, 23', 23") sont réalisés de préférence de telle sorte que lors du passage d'une pièce métallique ils envoient à la sortie des impulsions rectangulaires.

7. Dispositif selon l'une quelconque des revendications précédentes, caractérisé en ce que la direction de déplacement de la pièce métallique (12) à détecter est également prise en considération, en détectant la succession temporelle des impulsions apparaissant, en ce que l'impulsion envoyée par un détecteur partiel démarre de préférence une bascule (26) et la sortie de la bascule ainsi que celle d'un détecteur partiel suivant sont amenées à un élément ET (27), dont la sortie est appliquée conjointement avec la sortie du compteur (16) à un autre élément ET (28) qui envoie une impulsion de sortie (34) seulement et uniquement lorsque non seulement les détecteurs partiels (11, 11', 11'') ont envoyé successivement des impulsions, mais qu'en supplément, également les plans de détection (I, II et III) ont été traversés avec la succession donnée.

8. Dispositif selon la revendication 2, caractérisé en ce que les sorties des détecteurs partiels (11, 11', 11'') sont raccordées aux entrées d'un autre élément OU (32) qui déclenche, via un étage de retardement (33) et un autre élément OU (30) qui est attaqué de préférence également par un circuit auxiliaire (29) répondant au flanc descendant de la dernière impulsion, et qui déclenche la remise à zéro du compteur (16) après un certain temps qui est quelque peu plus long que le temps total de l'ensemble de la succession d'impulsions, et/ou en ce que le circuit logique (14') comprend un élément OU exclusif (15) dont l'entrée est raccordée aux détecteurs partiels (11, 11', 11'') et dont la sortie est raccordée d'une part à l'une des entrées d'un élément ET (36) et d'autre part via un étage d'inversion (34) à une bascule (35) dont la sortie pilote la seconde entrée dudit élément ET (36), la remise à zéro de la bascule (35) s'effectuant en particulier soit par le flanc arrière du signal de sortie du dernier détecteur partiel (11'), soit par l'une des deux impulsions de sortie des détecteurs partiels (11, 11'), et/ou en ce que la direction de passage de la pièce métallique à travers les détecteurs partiels (11, 11') est également prise en considération par un élément de commutation (31) conçu selon l'une ou l'autre des revendications 13 et 14.

9. Dispositif selon la revendication 2, caractérisé en ce que le circuit logique est formé par un registre à décalage.

10. Dispositif selon l'une quelconque des revendications précédentes, caractérisé en ce que les détecteurs partiels (11, 11', 11'') présentent en partie des régions de détection étroites et en partie des régions de détection larges, et en ce que la circuit logique qui suit est également adapté à ceci, tous les détecteurs partiels étant raccordés avantageusement à un seul oscillateur qui est en oscillation avec une seule fréquence, les plans de détection étant agencés de telle sorte les uns par rapport aux autres qu'aucun chevauchement d'impulsions de sortie voisines n'apparaît.
